# EUROPÄISCHE PATENTSCHRIFT

(11) **EP 0 817 380 B1**
(45) Veröffentlichungstag und Bekanntmachung des Hinweises auf die Patenterteilung: **20.08.2003**
(21) Anmeldenummer: 97109602.9
(22) Anmeldetag: 12.06.1997
(51) Int. Cl.: H03K 17/082, H03K 17/0814

(54) **Vorrichtung zum Schalten eines induktiven Verbrauchers**
Device for switching an inductive consumer
Dispositif de commutation d'un consommateur inductif

(30) Priorität: 02.07.1996 DE 19626630
(43) Veröffentlichungstag der Anmeldung: 07.01.1998
(73) Patentinhaber: SIEMENS AKTIENGESELLSCHAFT, 80333 München (DE)
(72) Erfinder: Förster, Ralf, 93055 Regensburg (DE)

(56) Entgegenhaltungen:
- EP-A- 0 072 523
- US-A- 4 893 211
- US-A- 5 453 900

## Beschreibung

Die Erfindung betrifft eine Vorrichtung zum Schalten eines induktiven Verbrauchers mit einem MOSFET-Schalter und mit Begrenzung der am Verbraucher liegenden Spannung.

Eine derartige Schaltung ist aus DE 31 09 650 A1 bekannt, wobei zwischen Drain und Gate eine zum Gate hin sperrende Zenerdiode in Reihe mit einer zum Gate hin stromdurchlässigen Sperrdiode angeordnet ist.

Aus EP 0 072 523 A2 ist eine Schutzschaltung gegen zu hohen Strom durch einen Feldeffekttransistor in einem Lastkreis bekannt, wobei ein von einer parallel zur gesteuerten Strecke des Feldeffekttransistors geschalteten Strommeßschaltung ein Schalter gesteuert wird, welcher die Steuerspannung am Steuereingeng des Feldeffekttransistors begrenzt.

Eine weitere Schutzschaltung gegen zu hohen Strom durch einen Feldeffekttransistor in einem Lastkreis ist aus US 4 893 211 A bekannt.

Aus SAX, H. u.a.: "Intelligente Leistungs-MOSFET" in Elektronik-Informationen Nr. 6, 1994, Seiten 26 und 27 ist eine Schutzschaltung für einen MOSFET gezeigt, bei welcher in der Gatezuleitung des MOSFET eine Parallelschaltung eines Schalters und eines Widerstandes angeordnet ist. Der Schalter überbrückt im normalen Betrieb den Widerstand und wird bei Überstrom, Übertemperatur oder Überspannung geöffnet.

Viele induktive Verbraucher, insbesondere Kraftstoff-Einspritzventile für Brennkraftmaschinen, sind so schnell wie möglich und mit geringer Streuung der Ausschaltzeit zu entmagnetisieren. In den meisten Fällen wird die am induktiven Verbraucher liegende Spannung mittels Zenerdioden auf einen bestimmten Wert (Zenerspannung) begrenzt, der möglichst groß gewählt wird, um ein schnelles Ausschalten zu ermöglichen, ohne jedoch die maximal zulässige Spannung der Halbleiterschalter zu überschreiten. Die Sperrspannungen solcher Zenerdioden sind jedoch mit großer Fertigungsstreuung behaftet und sehr temperaturabhängig. Dadurch sind auch die Ausschaltzeiten, d.h., die Entmagnetisierungszeiten bei Serienfertigung einer Streuung unterworfen und ändern sich temperaturabhängig. Beispielsweise bei solchen Schaltungen in Kraftstoff-Einspritzventilen für Brennkraftmaschinen weichen damit die tatsächlich eingespritzten Kraftstoffmengen von den berechneten Mengen je nach Exemplar und Temperatur mehr oder weniger ab.

Aufgabe der Erfindung ist es, eine Vorrichtung zum Schalten eines induktiven Verbrauchers zu schaffen, welche es ermöglicht, beim Ausschalten eine vorgegebene Spannung am Verbraucher exakt und weitgehend temperaturunabhängig einzuhalten und eine schnelle Entmagnetisierung des Verbrauchers mit konstanter Entmagnetisierungszeit sicherzustellen.

Diese Aufgabe wird erfindungsgemäß durch die Merkmale der Patentansprüche 1 und 2 gelöst.

Vorteilhafte Ausgestaltungen der Erfindung sind den Unteransprüchen zu entnehmen.

Ausführungsbeispiele der Erfindung sind im folgenden unter Bezugnahme auf die schematische Zeichnung näher erläutert. Es zeigen:
- Figur 1:: eine bekannte Vorrichtung zum Schalten eines induktiven Verbrauchers,
- Figur 2:: ein erstes schematisches Ausführungsbeispiel einer erfindungsgemäßen Vorrichtung, und
- Figur 3:: ein zweites schematisches Ausführungsbeispiel einer erfindungsgemäßen Vorrichtung.

Die beschriebenen und in den Figuren dargestellten Steuerund MOSFET-Schalter können auch beispielsweise IGBT- oder Bipolar-Darlington-Transistoren sein. Diese und die dargestellten pnp-Transistor-Schalter können jeweils durch Einzeltransistoren oder durch Transistorkombinationen ersetzt sein.

Es liegt auch im Rahmen der Erfindung, die mit Lowside-Schaltern ausgeführten Schaltungen durch solche mit Highside-Schaltern darzustellen, die sich nur durch inverse Transistortypen und Spannungsumpolungen von den beschriebenen und beanspruchten Schaltungen unterscheiden.

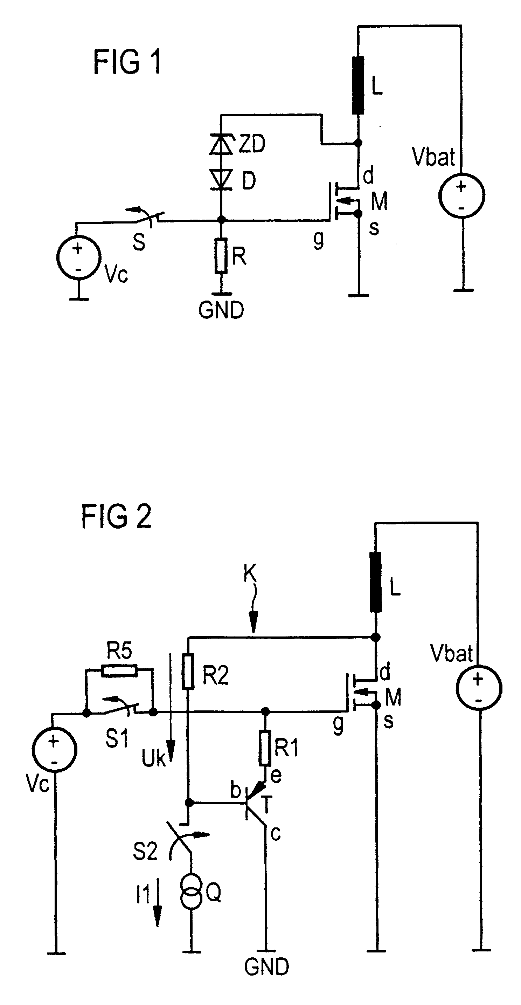

Figur 1 zeigt eine bekannte Schaltung, bei der ein induktiver Verbraucher L in Reihe mit einem Lowside-MOSFET-Schalter M an den Polen +Vbat und GND einer Betriebsspannungsquelle Vbat liegt, wobei der Drain d mit dem Verbraucher und die Source s mit dem Minuspol GND verbunden ist. Zwischen dem Gate g und dem Minuspol GND liegt üblicherweise ein Widerstand R und parallel zu diesem eine Steuerspannungsquelle Vc, deren Pluspol +Vc über einen Steuerschalter S mit dem Gate g verbunden ist. Der Minuspol -Vc der Steuerspannungsquelle Vc ist mit dem Minuspol GND der Betriebsspannungsquelle Vbat verbunden. Zwischen Drain d und Gate g ist eine zum Gate g hin sperrende Zenerdiode ZD in Reihe mit einer zum Gate g hin stromdurchlässigen Sperrdiode D angeordnet. Die Sperrdiode D verhindert bei leitendem MOSFET-Schalter M einen Stromfluß vom Gate g zu dem in diesem Fall auf niedrigem Potential liegenden Drain d.

Im ausgeschaltetem Zustand der Schaltung ist der Steuerschalter S geöffnet und damit der MOSFET-Schalter M nichtleitend bzw. hochohmig; es fließt kein Strom.

Zum Einschalten des Verbrauchers wird Steuerschalter S geschlossen und damit MOSFET-Schalter M leitend. Es fließt ein zunehmender Strom vom Pluspol +Vbat über den Verbraucher L und den MOSFET-Schalter M zum Minuspol GND. Der Verbraucher wird eingeschaltet.

Zum Abschalten des Verbrauchers L wird Schalter S geöffnet und das Gate g des MOSFET-Schalters M über den Widerstand R entladen. Das Potential am Drain d steigt an, bis bei Erreichen der Zenerspannung der Zenerdiode ZD ein Strom durch die Dioden ZD und D fließt, durch welchen das Gate g nachgeladen wird. Damit stellt sich ein konstantes Drainpotential ein, bis die Spule L entmagnetisiert ist.

Nachteilig an derartigen Schaltungen sind Streuung und Temperaturabhängigkeit der Zenerspannungen sowie die große Verlustleistung über der Zenerdiode, wenn das Gate g über einen kleinen Widerstand R schnell entladen werden soll. Außerdem ist eine Integration dieser Schaltung in einen Integrierten Schaltkreis üblicher Technologie (max. 35V) bei häufig geforderten Zenerspannungen von 80V bis 400V nicht möglich.

Figur 2 zeigt ein erstes, schematisches Ausführungsbeispiel einer erfindungsgemäßen Schaltvorrichtung, in welchem Betriebsspannungsquelle Vbat, Verbraucher L, MOSFET-Schalter M, Steuerspannungsquelle Vc und Steuerschalter S1, wie bereits bei Figur 1 beschrieben, angeordnet sind. Dem Steuerschalter S1 ist hier ein erster Widerstand R5 parallelgeschaltet. Anstelle der Zenerdiode ZD ist eine Klemmschaltung K vorgesehen. Diese besteht aus einem zweiten Widerstand R1, dessen einer Anschluß mit dem Gate g des MOSFET-Schalters M verbunden ist, aus einem pnp-Transistor T, dessen Emitter e mit dem anderen Anschluß des zweiten Widerstandes R1 verbunden ist und dessen Kollektor c mit dem Minuspol GND der Betriebsspannungsquelle Vbat verbunden ist, aus einer Konstantstromquelle Q, die einerseits mit dem Minuspol GND und andererseits über einen weiteren Schalter S2 mit der Basis b des pnp-Transistors T verbunden ist, und aus einem dritten Widerstand R2, der einerseits mit der Basis b des pnp-Transistors T und andererseits mit dem Drain d des MOSFET-Schalters M verbunden ist.

Im ausgeschalteten Zustand sind die Schalter S1 und S2 geöffnet und die Betriebsspannungsquelle Vbat und die Steuerspannungsquelle Vc können in nicht dargestellter Weise von der Schaltung getrennt sein und sind zumindest während des Betriebes mit ihr verbunden.

Zum Einschalten des Verbrauchers wird Steuerschalter S1 geschlossen und damit MOSFET-Schalter M leitend. Es fließt ein zunehmender Strom vom Pluspol +Vbat über den Verbraucher L und den MOSFET-Schalter M zum Minuspol GND. Der Verbraucher wird eingeschaltet.

Zum Abschalten des Verbrauchers L wird Schalter S1 geöffnet und gleichzeitig Schalter S2 geschlossen. Durch die Konstantstromquelle Q fließt vom Gate g über den Widerstand R1, die Emitter-Basisstrecke des pnp-Transistors T ein Strom I1 zum Minuspol GND, der den Transistor T leitend steuert, wodurch das Gate g des MOSFET-Schalters M entladen wird. Das Drainpotential steigt an, und es fließt ein zunehmender Teil des Stromes I1 vom Drain d über den dritten Widerstand R2 in die Konstantstromquelle Q. Wenn das Drainpotential einen Wert erreicht hat, bei dem der gesamte Strom I1 durch den Widerstand R2 fließt, wird Transistor T wieder nichtleitend und die Entladung des Gates g wird unterbrochen.

Während der Klemmung stellt sich am Drain d eine Spannung ein, die im wesentlichen von der Spannung Uk = I1*R2 am Widerstand R2 abhängt. Über den Widerstand R5 erfolgt eine geringe Nachladung des Gates g. Mit der Größe des Widerstandes R1 kann die Geschwindigkeit der Gate-Entladung bestimmt werden. Mit der Größe des Widerstandes R2 und des Stromes I1 kann die gewünschte Klemmspannung Uk - die der Zenerspannung der Schaltung nach Figur 1 entspricht - eingestellt werden. Diese Schaltung kann auch für große Klemmspannungen mit Ausnahme des dritten Widerstandes R2 ohne weiteres in einen IC üblicher Technologie integriert werden.

Mit der beschriebenen Schaltung nach Figur 2 ist allerdings ein Chopperbetrieb (periodisches Nachladen im Einschaltzustand) nicht möglich. Dazu müsste dem Verbraucher eine Freilaufdiode parallelgeschaltet sein, die wiederum ein schnelles Entmagnetisieren verhindern würde.

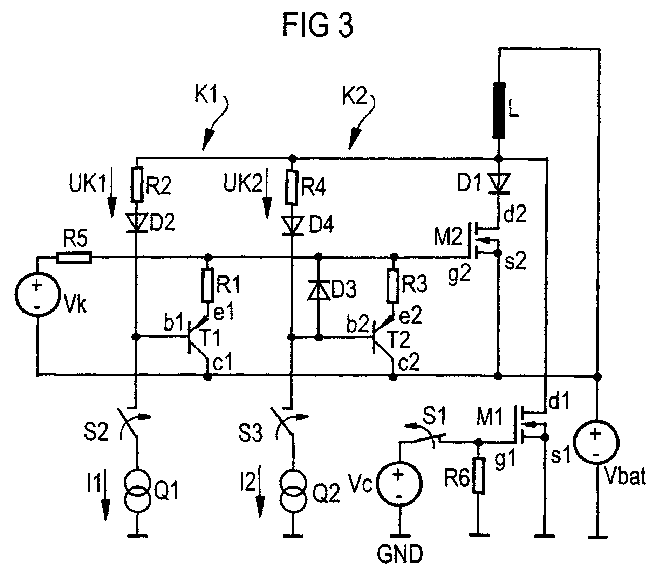

In Figur 3 ist ein weiteres schematisches Ausführungsbeispiel einer erfindungsgemäßen Schaltvorrichtung dargestellt, bei der auch Chopperbetrieb möglich ist.

Bei dieser Schaltung ist eine zwischen dem Pluspol +Vbat und dem Minuspol GND der Betriebsspannungsquelle Vbat liegende Reihenschaltung aus einem Verbraucher L und einem elektronischen Lowside-MOSFET-Schalter M1 angeordnet. Zwischen dem Gate g1 des MOSFET-Schalters M1 und dem Minuspol GND der Betriebsspannungsquelle Vbat liegt ein vierter Widerstand R6 und parallel zum vierten Widerstand R6 eine Reihenschaltung aus einem Steuerschalter S1 und einer Steuerspannungsquelle Vc, deren Minuspol -Vc mit dem Minuspol GND der Betriebsspannungsquelle Vbat verbunden ist. Parallel zum Verbraucher L ist eine Reihenschaltung aus einer Freilaufdiode D1 und einem weiteren MOSFET-Schalter M2 angeordnet. Eine weitere Spannungsquelle Vk ist mit ihrem Minuspol -Vk mit der Source s2 des weiteren MOSFET-Schalters M2 und mit dem Pluspol +Vbat der Betriebsspannungsquelle Vbat verbunden, und mit ihrem Pluspol +Vk über einen ersten Widerstand R5 mit dem Gate g2 des weiteren MOSFET-Schalters M2 verbunden.

Die Schaltung weist zunächst eine Klemmschaltung K1 mit einem zweiten Widerstand R1 auf, dessen einer Anschluß mit dem Gate g2 des weiteren MOSFET-Schalters M2 verbunden ist. Des weiteren ist ein pnp-Transistor T1 vorgesehen, dessen Emitter e1 mit dem anderen Anschluß des zweiten Widerstandes R1 verbunden ist, und dessen Kollektor c1 mit dem Pluspol +Vbat der Betriebsspannungsquelle Vbat verbunden ist. Eine auf einen zum vollständigen Öffnen des pnp-Transistors T1 ausreichenden und eine gewünschte Klemmspannung Uk1 bewirkenden Konstantstrom I1 eingestellte Konstantstromquelle Q1 ist einerseits mit dem Minuspol GND der Betriebsspannungsquelle Vbat und andererseits über einen Schalter S2 mit der Basis b1 des pnp-Transistors T1 verbunden, und zwischen dem Verbraucher L und der Basis des pnp-Transistors T1 ist eine Reihenschaltung aus einem dritten Widerstand R2 und einer Sperrdiode D2 angeordnet.

Darüber hinaus ist parallel zur Klemmschaltung K1 eine weitere Klemmschaltung K2 angeordnet, mit einem fünften Widerstand R3, dessen einer Anschluß mit dem Gate g2 des weiteren MOSFET-Schalters M2 verbunden ist. Des weiteren ist ein pnp-Transistor T2 vorgesehen, dessen Emitter e2 mit dem anderen Anschluß des fünften Widerstandes R3 verbunden ist, und dessen Kollektor c2 mit dem Pluspol +Vbat der Betriebsspannungsquelle Vbat verbunden ist. Eine auf einen zum vollständigen Öffnen des pnp-Transistors T2 ausreichenden und eine gewünschte Klemmspannung Uk2 < Uk1 bewirkenden Konstantstrom I2 eingestellte Konstantstromquelle Q2 ist einerseits mit dem Minuspol GND der Betriebsspannungsquelle Vbat und andererseits über einen Schalter S3 mit der Basis b2 des pnp-Transistors T2 verbunden, und zwischen dem Verbraucher L und der Basis b2 des pnp-Transistors T2 ist eine Reihenschaltung aus einem sechsten Widerstand R4 und einer Sperrdiode D4 angeordnet.

Im ausgeschalteten Zustand sind bei dieser Schaltung alle Schalter S1, S2 und S3 geöffnet und die Spannungsquelle Vc über S1 von der Schaltung getrennt.

Zum Einschalten des Verbrauchers wird Steuerschalter S1 geschlossen und damit MOSFET-Schalter M1 leitend. Es fließt ein zunehmender Strom vom Pluspol +Vbat über den Verbraucher L und den MOSFET-Schalter M1 zum Minuspol GND. Der Verbraucher wird eingeschaltet. Im eingeschalteten Zustand kann der Verbraucher L z.B. durch getakteten Betrieb des Schalters S1 mit einem bestimmten Tastverhältnis nachgeladen werden (Chopper-Betrieb), um einen bestimmten Verbraucherstrom aufrecht zu erhalten. Während des Chopper-Betriebes übernimmt bei ausgeschaltetem MOSFET-Schalter M1 der Freilaufkreis (Freilaufdiode D1 und MOSFET-Schalter M2) den Strom durch die Last L.

Die Entmagnetisierungszeit eines induktiven Verbrauchers wird von der an ihm liegenden Spannung bestimmt. In den Schaltungen nach den Figuren 1 und 2 ist diese Spannung neben der Zener- bzw. Klemmspannung auch abhängig von der Betriebsspannung Vbat.

Bei dem Ausführungsbeispiel nach Figur 3 ist diese Abhängigkeit von der Betriebsspannung Vbat beseitigt, indem über den Freilaufkreis auf eine unabhängige Spannung (Ukl bzw. Uk2) geklemmt wird.

Wie bei dem Ausführungsbeispiel nach Figur 2 ist es prinzipie11 möglich, eine einzige Klemmschaltung vorzusehen. Um aber dort ein durch Transistorkapazitäten bedingtes zu großes Überschwingen des Potentials am Drain d (Figur 2) bzw. am Drain d1 (Figur 3) beim Abschalten des Verbrauchers L zu vermeiden, darf der zweite Widerstand R1 zwischen dem Gate g des MOSFET-Schalters M und dem Emitter e des pnp-Transistors T nicht zu klein gewählt werden, was aber bedeutet, daß der MOSFET-Schalter M2 langsam und nach großer Totzeit öffnet und daß die Entmagnetisierungszeit des Verbrauchers nicht beliebig klein werden kann. Bei erfindungsgemäßer Verwendung zweier Klemmschaltungen K1 und K2, wie nachstehend erläutert, kann aber das Gate g2 des MOSFET-Schalters M2 schneller entladen werden und die Entmagnetisierung des Verbrauchers ohne zu großes Überschwingen beschleunigt werden.

Die beiden parallel zueinander angeordneten Klemmschaltungen K1 und K2 werden so dimensioniert, daß unterschiedliche Klemmspannungen Uk1 > Uk2, mit Uk1 = I1*R2 und Uk2 = I2*R4, erreicht werden, wobei R3 < R1 ist.

Zum Entmagnetisieren des Verbrauchers L wird Schalter S1 geöffnet. Gleichzeitig werden die Schalter S2 und S3 geschlossen. Dadurch fließen vom Gate g2 ein Strom I1 über R1-e2-b1-Q1 und ein Strom I2 über R3-e2-b2-Q2 nach GND und über Vbat zum Minuspol -Vk und fließen entsprechend verstärkte Ströme I1*v1 und I2*v2 über R1-e1-c1 bzw. über R3-e2-c2 zum Minuspol -Vk, wodurch das Gate g2 des MOSFET-Schalters M2 entladen wird. Dadurch steigt das Potential am Drain d2 an, bis bei Erreichen der Klemmspannung Uk2 der gesamte Strom I2 über den Widerstand R4 fließt und der pnp-Transistor T2 nichtleitend wird.

Deshalb wird im weiteren Verlauf das Gate g2 nur noch mit einem Strom I1*v1 ausgeräumt, bis der Verbraucher entmagnetisiert ist, wodurch großes Überschwingen sicher vermieden. wird.

Durch die Sperrdiode D3, die von der Basis b2 des pnp-Transistors T2 zum Gate g2 des MOSFET-Schalters M2 stromdurchlässig ist, wird eine zu große Sperrspannung an der Basis-Emitter-Strecke des pnp-Transistors T2 vermieden.

## Patentansprüche

1. Vorrichtung zum Schalten eines induktiven Verbrauchers (L), insbesondere eines Kraftstoffeinspritzventils einer Brennkraftmaschine,
mit einer zwischen dem Pluspol (+Vbat) und dem Minuspol (GND) einer Betriebsspannungsquelle (Vbat) liegenden Reihenschaltung aus dem Verbraucher (L) und einem elektronischen Lowside-MOSFET-Schalter (M),
mit einer zwischen dem Gate (g) des MOSFET-Schalters (M) und dem Minuspol (GND) der Betriebsspannungsquelle (Vbat) liegenden Reihenschaltung aus einem Steuerschalter (S1) und einer Steuerspannungsquelle (Vc), deren Minuspol (-Vc) mit dem Minuspol (GND) der Betriebsspannungsquelle (Vbat) verbunden ist,
mit einem dem Steuerschalter (S1) parallelgeschalteten ersten Widerstand (R5), und
mit einer Klemmschaltung (K), bestehend aus:
- einem zweiten Widerstand (R1), dessen einer Anschluß mit dem Gate (g) des MOSFET-Schalters (M) verbunden ist,
- einem pnp-Transistor (T), dessen Emitter (e) mit dem anderen Anschluß des zweiten Widerstandes (R1) verbunden ist, und dessen Kollektor (c) mit dem Minuspol (GND) der Betriebsspannungsquelle (Vbat) verbunden ist,
- einer Konstantstromquelle (Q), die einerseits mit dem Minuspol (GND) und andererseits über einen Schalter (S2) mit der Basis (b) des pnp-Transistors (T) verbunden ist, und
- einem dritten Widerstand (R2), der einerseits mit der Basis (b) des pnp-Transistors (T) und andererseits mit dem Drain (d) des MOSFET-Schalters (M) verbunden ist.

2. Vorrichtung zum Schalten eines induktiven Verbrauchers (L), insbesondere eines Kraftstoffeinspritzventils einer Brennkraftmaschine,
mit einer zwischen dem Pluspol (+Vbat) und dem Minuspol (GND) einer Betriebsspannungsquelle (Vbat) liegenden Reihenschaltung aus dem Verbraucher (L) und einem elektronischen Lowside-MOSFET-Schalter (M1),
mit einem zwischen dem Gate (g1) des MOSFET-Schalters (M1) und dem Minuspol (GND) der Betriebsspannungsquelle (Vbat) liegenden vierten Widerstand (R6) und mit einer parallel zum vierten Widerstand (R6) liegenden Reihenschaltung aus einem Steuerschalter (S1) und einer Steuerspannungsquelle (Vc), deren Minuspol (-Vc) mit dem Minuspol (GND) der Betriebsspannungsquelle (Vbat) verbunden ist,
mit einer parallel zum Verbraucher (L) angeordneten Reihenschaltung aus einer Freilaufdiode (D1) und einem weiteren MOSFET-Schalter (M2),
mit einer weiteren Spannungsquelle (Vk), deren Minuspol (-Vk) mit der Source (s2) des weiteren MOSFET-Schalters (M2) und mit dem Pluspol (+Vbat) der Betriebsspannungsquelle (Vbat) verbunden ist und deren Pluspol (+Vk) über einen ersten Widerstand (R5) mit dem Gate (g2) des weiteren MOSFET-Schalters (M2) verbunden ist, und
mit einer ersten Klemmschaltung(K1), bestehend aus:
- einem zweiten Widerstand (R1), dessen einer Anschluß mit dem Gate (g2) des weiteren MOSFET-Schalters (M2) verbunden ist,
- einem ersten pnp-Transistor (T1), dessen Emitter (e1) mit dem anderen Anschluß des zweiten Widerstandes (R1) verbunden ist, und dessen Kollektor (c1) mit dem Pluspol (+Vbat) der Betriebsspannungsquelle (Vbat) verbunden ist,
- einer ersten Konstantstromquelle (Q1), die einerseits mit dem Minuspol (GND) der Betriebsspannungsquelle (Vbat) und andererseits über einen ersten Schalter (S2) mit der Basis (b1) des ersten pnp-Transistors (T1) verbunden ist, und
- einer Reihenschaltung aus einem dritten Widerstand (R2), der einerseits mit dem Verbraucher verbunden ist, und einer ersten Sperrdiode (D2), die mit der Basis (b1) des ersten pnp-Transistors (T1) verbunden ist.

3. Vorrichtung nach Anspruch 2, **dadurch gekennzeichnet, daß** parallel zur ersten Klemmschaltung (K1) eine zweite Klemmschaltung (K2) angeordnet ist, bestehend aus:
- einem fünften Widerstand (R3), dessen einer Anschluß mit dem Gate (g2) des weiteren MOSFET-Schalters (M2) verbunden ist,
- einem zweiten pnp-Transistor (T2), dessen Emitter (e2) mit dem anderen Anschluß des fünften Widerstandes (R3) verbunden ist, und dessen Kollektor (c2) mit dem Pluspol (+Vbat) der Betriebsspannungsquelle (Vbat) verbunden ist,
- einer zweiten Konstantstromquelle (Q2), die einerseits mit dem Minuspol (GND) der Betriebsspannungsquelle (Vbat) und andererseits über einen zweiten Schalter (S3) mit der Basis (b2) des zweiten pnp-Transistors (T2) verbunden ist, und
- einer Reihenschaltung aus einem sechsten Widerstand (R4), der einerseits mit dem Verbraucher (L) verbunden ist, und einer zweiten Sperrdiode (D4), die mit der Basis (b2) des zweiten pnp-Transistors (T2) verbunden ist.

4. Vorrichtung nach Anspruch 3, **dadurch gekennzeichnet, daß** die beiden Klemmschaltungen (K1, K2) so dimensioniert sind, daß unterschiedliche Klemmspannungen Uk1 > Uk2 entstehen, mit Uk1 = I1*R2, Uk2 = I2*R4 und mit R3 < R1, wobei R2 der dritte Widerstand, R4 der sechste Widerstand, I1 der Strom der ersten Konstantstromquelle (Q1), I2 der Strom der zweiten Konstantstromquelle (Q2), R3 der fünfte Widerstand und R1 der zweite Widerstand ist.

5. Vorrichtung nach Anspruch 3, **dadurch gekennzeichnet, daß** eine von der Basis (b2) des zweiten pnp-Transistors (T2) zum Gate (g2) des weiteren MOSFET-Schalters (M2) stromdurchlässige dritte Sperrdiode (D3) vorgesehen ist.

## Claims

1. Device for switching an inductive consumer (L), particularly a fuel injection valve of an internal combustion engine,
with a series circuit consisting of the consumer (L) and an electronic lowside MOSFET switch (M) located between the positive pole (+Vbat) and the negative pole (GND) of an operating voltage source (Vbat),
with a series circuit consisting of a control switch (S1) and a control voltage source (Vc), whose negative pole (-Vc) is connected to the negative pole (GND) of the operating voltage source (Vbat), located between the gate (g) of the MOSFET switch (M) and the negative pole (GND) of the operating voltage source (Vbat),
with a first resistor (R5) connected in parallel with the control switch (S1), and
with a clamp circuit (K), consisting of:
- a second resistor (R1), one terminal of which is connected to the gate (g) of the MOSFET switch (M),
- a pnp transistor (T) whose emitter (e) is connected to the other terminal of the second resistor (R1) and whose collector (c) is connected to the negative pole (GND) of the operating voltage source (Vbat),
- a constant current source (Q) which on one side is connected to the negative pole (GND) and on the other side via a switch (S2) to the base (b) of the pnp transistor (T), and
- a third resistor (R2), which on one side is connected to the base (b) of the pnp transistor (T) and on the other side to the drain (d) of the MOSFET switch (M).

2. Device for switching an inductive consumer (L), particularly a fuel injection valve of an internal combustion engine,
with a series circuit consisting of the consumer (L) and an electronic lowside MOSFET switch (M1) located between the positive pole (+Vbat) and the negative pole (GND) of an operating voltage source (Vbat),
with a fourth resistor (R6) located between the gate (g1) of the MOSFET switch (M1) and the negative pole (GND) of the operating voltage source (Vbat) and with a series circuit consisting of a control switch (S1) and a control voltage source (Vc), whose negative pole (-Vc) is connected to the negative pole (GND) of the operating voltage source (Vbat), located parallel to the fourth resistor (R6),
with a series circuit consisting of a freewheeling diode (D1) and a further MOSFET switch (M2) arranged in parallel to the consumer (L),
with a further voltage source (Vk), whose negative pole (-Vk) is connected to the source (s2) of the further MOSFET switch (M2) and the positive pole (+Vbat) of the operating voltage source (Vbat), and whose positive pole (+Vk) is connected via a first resistor (R5) to the gate (g2) of the further MOSFET switch (M2), and
with a first clamp circuit (K1), consisting of:
- a second resistor (R1), one terminal of which is connected to the gate (g2) of the further MOSFET switch (M2),
- a first pnp transistor (T1), whose emitter (el) is connected to the other terminal of the second resistor (R1), and whose collector (c1) is connected to the positive pole (+Vbat) of the operating voltage source (Vbat),
- a first constant current source (Q1), which on one side is connected to the negative pole (GND) of the operating voltage source (Vbat) and on the other side via a first switch (S2) to the base (b1) of the first pnp transistor (T1), and
- a series circuit consisting of a third resistor (R2), which on one side is connected to the consumer and to a first blocking diode (D2), which is connected to the base (b1) of the first pnp transistor (T1).

3. Device according to Claim 2, **characterised in that** a second clamp circuit (K2) is arranged parallel to the first clamp circuit (K1), consisting of:
- a fifth resistor (R3), one terminal of which is connected to gate (g2) of the further MOSFET switch (M2),
- a second pnp transistor (T2), whose emitter (e2) is connected to the other terminal of the fifth resistor (R3) and whose collector (c2) is connected to the positive pole (+Vbat) of the operating voltage source (Vbat),
- a second constant current source (Q2) which on one side is connected to the negative pole (GND) of the operating voltage source (Vbat) and on the other side via a second switch (S3) to the base (b2) of the second pnp transistor (T2), and
- a series circuit consisting of a sixth resistor (R4), which on one side is connected to the consumer (L), and a second blocking diode (D4) that is connected to the base (b2) of the second pnp transistor (T2).

4. Device according to Claim 3, **characterised in that** both clamp circuits (K1, K2) are dimensioned so that different clamping voltages Uk1 > Uk2 are produced, with Uk1 = I1*R2, Uk2 = I2*R4 and with R3 < R1, with R2 being the third resistor, R4 the sixth resistor, I1 the current of the first constant current source (Q1), I2 the current of the second constant current (Q2), R3 the fifth resistor and R1 the second resistor.

5. Device according to Claim 3, **characterised in that** a third blocking diode (D3) is provided which is conducting from the base (b2) of the second pnp transistor (T2) to the gate (g2) of the further MOSFET switch (M2).

## Revendications

1. Dispositif de commutation d'un consommateur inductif (L), en particulier d'une soupape d'injection de carburant d'un moteur à combustion interne,
avec un montage en série placé entre le pôle positif (+Vbat) et le pôle négatif (GND) d'une source de tension de fonctionnement (Vbat) et composé du consommateur (L) et d'un commutateur électronique MOSFET côté potentiel bas (M),
avec un montage en série placé entre la grille (g) du commutateur MOSFET (M) et le pôle négatif (GND) de la source de tension de fonctionnement (Vbat) et composé d'un interrupteur de commande (S1) et d'une source de tension de commande (Vc), dont le pôle négatif (-Vc) est raccordé au pôle négatif (GND) de la source de tension de fonctionnement (Vbat),
avec une première résistance (R5) montée en parallèle avec l'interrupteur de commande (S1), et
avec un circuit de verrouillage (K), se composant de:
- une deuxième résistance (R1), dont une première borne est raccordée à la grille (g) du commutateur MOSFET (M),
- un transistor PNP (T), dont l'émetteur (e) est raccordé à l'autre borne de la deuxième résistance (R1), et dont le collecteur (c) est raccordé au pôle négatif (GND) de la source de tension de fonctionnement (Vbat),
- une source de courant constant (Q), qui est raccordée d'une part au pôle négatif (GND) et d'autre part, via un interrupteur (S2), à la base (b) du transistor PNP (T), et
- une troisième résistance (R2), qui est raccordée d'une part à la base (b) du transistor PNP (T) et d'autre part au drain (d) du commutateur MOSFET (M).

2. Dispositif de commutation d'un consommateur inductif (L), en particulier d'une soupape d'injection de carburant d'un moteur à combustion interne,
avec un montage en série placé entre le pôle positif (+Vbat) et le pôle négatif (GND) d'une source de tension de fonctionnement (Vbat) et composé du consommateur (L) et d'un commutateur électronique MOSFET côté potentiel bas (M1),
avec une quatrième résistance (R6) placée entre la grille (g1) du commutateur MOSFET (M1) et le pôle négatif (GND) de la source de tension de fonctionnement (Vbat) et avec un montage en série placé en parallèle avec la quatrième résistance (R6) et composé d'un interrupteur de commande (S1) et d'une source de tension de commande (Vc) dont le pôle négatif (-Vc) est raccordé au pôle négatif (GND) de la source de tension de fonctionnement (Vbat),
avec un montage en série disposé en parallèle avec le consommateur (L) et composé d'une diode à roue libre (D1) et d'un autre commutateur MOSFET (M2),
avec une autre source de tension (Vk), dont le pole négatif (-Vk) est raccordé à la source (s2) de l'autre commutateur MOSFET (M2) et au pôle positif (+Vbat) de la source de tension de fonctionnement (Vbat), et dont le pôle positif (+Vk) est raccordé via une première résistance (R5) à la grille (g2) de l'autre commutateur MOSFET (M2), et
avec un premier circuit de verrouillage (K1), se composant de:
- une deuxième résistance (R1), dont une première borne est raccordée à la grille (g2) de l'autre commutateur MOSFET (M2),
- un premier transistor PNP (T1), dont l'émetteur (e1) est raccordé à l'autre borne de la deuxième résistance (R1), et dont le collecteur (c1) est raccordé au pôle positif (+Vbat) de la source de tension de fonctionnement (Vbat),
- une première source de courant constant (Q1), qui est raccordée d'une part au pôle négatif (GND) de la source de tension de fonctionnement (Vbat) et d'autre part, via un premier interrupteur (S2), à la base (b1) du premier transistor PNP (T1), et
- un montage en série composé d'une troisième résistance (R2), qui est raccordée d'une part au consommateur, et d'une première diode de blocage (D2), qui est raccordée à la base (b1) du premier transistor PNP (T1).

3. Dispositif suivant la revendication 2, **caractérisé en ce qu'**un second circuit de verrouillage (K2) est disposé en parallèle avec le premier circuit de verrouillage (K1) et se compose de:
- une cinquième résistance (R3), dont une première borne est raccordée à la grille (g2) de l'autre commutateur MOSFET (M2),
- un second transistor PNP (T2), dont l'émetteur (e2) est raccordé à l'autre borne de la cinquième résistance (R3), et dont le collecteur (c2) est raccordé au pôle positif (+Vbat) de la source de tension de fonctionnement (Vbat),
- une seconde source de courant constant (Q2), qui est raccordée d'une part au pôle négatif (GND) de la source de tension de fonctionnement (Vbat) et d'autre part, via un second interrupteur (S3), à la base (b2) du second transistor PNP (T2), et
- un montage en série composé d'une sixième résistance (R4), qui est raccordée d'une part au consommateur (L), et d'une deuxième diode de blocage (D4), qui est raccordée à la base (b2) du second transistor PNP (T2).

4. Dispositif suivant la revendication 3, **caractérisé en ce que** les deux circuits de verrouillage (K1, K2) sont dimensionnés de telle façon qu'il apparaisse des tensions de verrouillage différentes Uk1 > Uk2, avec Uk1 = I1*R2, Uk2 = I2*R4 et avec R3 < R1, où R2 est la troisième résistance, R4 est la sixième résistance, I1 est le courant de la première source de courant constant (Q1), I2 est le courant de la seconde source de courant constant (Q2), R3 est la cinquième résistance et R1 est la deuxième résistance.

5. Dispositif suivant la revendication 3, **caractérisé en ce qu'**il est prévu une troisième diode de blocage (D3) laissant passer le courant depuis la base (b2) du second transistor PNP (T2) vers la grille (g2) de l'autre commutateur MOSFET (M2).
